**Europäisches Patentamt**

**European Patent Office**

**Office européen des brevets**

(19)

(11) Veröffentlichungsnummer : **0 511 162 A1**

(12) **EUROPÄISCHE PATENTANMELDUNG**

(21) Anmeldenummer : 92810279.7

(22) Anmeldetag : 15.04.92

(51) Int. Cl.⁵ : **H01L 23/373, H01L 23/495**

(30) Priorität : 24.04.91 CH 1226/91
10.07.91 CH 2056/91

(43) Veröffentlichungstag der Anmeldung :
28.10.92 Patentblatt 92/44

(84) Benannte Vertragsstaaten :
BE CH DE FR GB IT LI NL SE

(71) Anmelder : CIBA-GEIGY AG
Klybeckstrasse 141
CH-4002 Basel (CH)

(72) Erfinder : Bujard, Patrice, Dr.
Grande-Fin
CH-1784 Courtepin (CH)

(54) **Wärmeleitende Klebfilme, Laminate mit wärmeleitenden Klebschichten und deren Verwendung.**

(57)    Laminat aus (a) einem Trägermaterial mit einer Wärmeleitfähigkeit von mindestens 10 W/mK und einer Dicke von 10 bis 100 $\mu$m, bei dem (b) auf mindestens einer Oberfläche eine dielektrische Klebschicht aufgebracht ist, die einen wärmeleitenden Füllstoff enthält, und die eine Dicke von 5 bis 500 $\mu$m und eine Wärmeleitfähigkeit von mindestens 1 W/mK aufweist.

Das flexible Laminat oder ein dielektrischer und selbsttragender Klebfilm, der einen wärmeleitenden Füllstoff enthält und eine Wärmeleitfähigkeit von mindestens 1 W/mK aufweist, eignen sich zur Ableitung von Wärme bei Montagestreifen, die elektrisch isolierte Auflageflächen für elektrische und elektronische Bauteile enthalten und mit einem Kunststoff umhüllt sind, zum Beispiel DIP-Gehäusen, indem man die Rückseiten der Auflageflächen mit den elektrischen Leiterbahnen verklebt.

FIGUR 1

EP 0 511 162 A1

Die vorliegende Erfindung betrifft ein Laminat aus (a) einem wärmeleitenden Substrat, und (b) einer auf mindestens einer Oberfläche aufgebrachten dielektrischen Klebschicht, die einen wärmeleitenden Füllstoff enthält, die Verwendung dieses Laminats oder eines dielektrischen Klebfilms, der einen wärmeleitenden Füllstoff enthält, zur Wärmeableitung in elektrischen und elektronischen Bauteilen, und Montagestreifen (lead-frame), die dieses Laminat oder diesen Klebfilm als Wärmebrücke zur Ableitung von Wärme enthalten, sowie DIP-Gehäuse (Dual In-Line Package) mit diesen Montagestreifen.

Der thermische Widerstand von mit Kunststoffen umhüllten elektronischen Bauteilen ist eine wichtige Kenngrösse für deren zuverlässige Funktion. Der thermische Widerstand, der mit $\Theta_{JA}$ bezeichnet und in der Einheit K/W gemessen wird, gibt die Temperaturdifferenz zwischen dem Bauteil und der Umgebung an, die durch eine Wärmeleistung von 1 Watt erzeugt wird. Der maximal zulässige thermische Widerstand ist durch die Verlustenergie des Bauteils, die Umgebungstemperatur und die für den Bauteil maximal tolerierbare Temperatur gegeben. Die geforderte Spezifikation kann bis zu einem gewissen Grad durch die Materialwahl sowie konstruktive Massnahmen erfüllt werden.

Die zunehmende Miniaturisierung elektronischer Bauteile erfordert eine wirkungsvolle Ableitung der beim Betrieb entstehenden Wärme. Es wurde schon vorgeschlagen, die Wärme mit einer unflexiblen Metallplatte als Wärmeverteiler abzuleiten, die elektrisch isoliert unter dem Montagestreifen angebracht wird. Als Material werden für den Wärmeverteiler zum Beispiel Metalle und Metallegierungen [siehe J. A. Andrews et al., IEEE Transactions on Components, Hybrids and Manufacturing Technology, Vol. CHMT-4, No. 4, Seiten 455-461 (1981)] oder Keramiken wie zum Beispiel SiC [siehe J. W. McPherson et al., International Reliability Physical Symposium, Seiten 224-228 (1987)] verwendet. Der thermische Widerstand kann hierbei um bis zu 50 % verbessert werden. Die thermischen Ausdehnungen von Montagestreifen, Wärmeverteiler und Kunststoffen sind jedoch so unterschiedlich, dass die thermomechanische Beanspruchung solcher Bauteile deren Funktionsfähigkeit und Lebensdauer einschränken kann.

Es wurde nun gefunden, dass man mit einem flexiblen Laminat aus wärmeleitenden Trägermaterialien und Klebschichten oder mit einem wärmeleitenden selbsttragenden Klebfilm eine ausgezeichnete Wärmeableitung über einen Montagestreifen erzielen und mögliche Schädigungen durch thermomechanische Beanspruchungen erheblich reduzieren kann, wenn man den elektrisch isolierten Teil eines metallischen Montagestreifens und dessen elektrische Leiterbahnen mit diesem Laminat beziehungsweise Klebfilm verklebt. Die Wärmeleitung ist so hoch, dass man auf hochgefüllte wärmeleitende Umhüllungsharze verzichten und an deren Stelle sogar ungefüllte oder gering gefüllte Harze verwenden kann, wodurch Schädigungen durch thermomechanische Beanspruchungen weiter vermindert werden können.

Ein Gegenstand der Erfindung ist ein Laminat aus (a) einem Trägermaterial mit einer Wärmeleitfähigkeit von mindestens l0 W/mK und einer Dicke von l0 bis l00 μm, bei dem (b) auf mindestens einer Oberfläche eine dielektrische Klebschicht aufgebracht ist, die einen wärmeleitenden Füllstoff enthält, und die eine Dicke von 5 bis 500 μm und eine Wärmeleitfähigkeit von mindestens 1 W/mK aufweist.

Das Trägermaterial kann zum Beispiel aus Filmen, Folien oder Geweben von Metallen, Metallegierungen oder Kunststoffen mit hoher Wärmeleitfähigkeit und Schmelzpunkten von mehr als etwa 150 °C oder aus Geweben von Kohlenstoff- oder Keramikfasern bestehen. Bevorzugt sind Metalle und Metallegierungen, deren Oberflächen zur Erzielung einer guten elektrischen Isolierung oxidiert sein können. Bevorzugte Metalle und Metallegierungen sind Kupfer, Nickel, Zink, Aluminium und Legierungen aus Kupfer und Nickel. Besonders bevorzugt besteht das Trägermaterial aus gegebenenfalls oberflächlich oxidiertem Aluminium oder Kupfer.

Die Wärmeleitfähigkeit des Trägermaterials beträgt bevorzugt mindestens 20 W/mK und die Dicke beträgt bevorzugt 10 bis 70 μm und besonders bevorzugt 20 bis 60 μm.

Die Dicke der Klebschicht beträgt bevorzugt 20 bis 300 μm und besonders bevorzugt 50 bis 250 μm. Die Wärmeleitfähigkeit der Klebschicht beträgt bevorzugt mindestens 1,5 W/mK und sie kann bis zu etwa 5 W/mK betragen.

Klebstoffe sind in grosser Zahl bekannt und dem Fachmann geläufig. Es kann sich um pastöse, zähflüssige oder feste Klebstoffe handeln, wobei auf der Klebschicht eine Schutzfolie aufgebracht sein kann, die vor der Verarbeitung entfernt wird. Es ist auch möglich, direkt vor der Verarbeitung flüssige oder schmelzflüssige Klebstoffe auf das Trägermaterial aufzubringen. Ferner können auch Klebfilme und Schmelzkleber Verwendung finden. Geeignete Klebstoffe sind zum Beispiel solche auf der Basis von Epoxidharzen, Polyurethanen, Polyacrylaten, Siliconen und Thermoplasten wie zum Beispiel Polyamide und Polyester. Bevorzugte Klebstoffe sind Epoxidharze, insbesondere solche auf der Basis von gegebenenfalls vorverlängerten Bisphenol-A-Diglycidylethern, die einen latenten Härter und gegebenenfalls einen Härtungsbeschleuniger enthalten. Epoxidklebfilme sind zum Beispiel von L. M. Leung in Hybrid Circuits, No. 18, Seiten 22 -24 (1989) beschrieben.

Der Füllstoff kann feinteilig sein und weist dann im allgemeinen eine Partikelgrösse auf, die nicht grösser und bevorzugt kleiner als die Dicke der Klebschicht ist. Zur Erzielung einer hohen Wärmeleitfähigkeit werden zweckmässig hochgefüllte Systeme verwendet. Der Gehalt an feinteiligem Füllstoff kann zum Beispiel 25 bis 90 Gew.-%, bevorzugt 30 bis 80 Gew.-% betragen. Der Gehalt hängt im wesentlichen von der Wärmeleitfähigkeit der feinteiligen Füllstoffe ab. Der Füllstoff kann auch plättchen-, nadel- oder faserförmig sein. Solche Füllstoffe führen im allgemeinen zu einer höheren Wärmeleitfähigkeit der Klebschichten, so dass geringere Füllgrade ermöglicht werden, zum Beispiel 5 bis 40 Gew.-%. Die Mengen sind auf das Gewicht der Klebschicht bezogen. Die Füllstoffe sind keine elektrischen Leiter, also bevorzugt dielektrisch.

Geeignete und häufig verwendete wärmeleitende und dielektrische Füllstoffe sind zum Beispiel natürliche oder synthetische Mineralien und keramische Werkstoffe, wie zum Beispiel Diamant, Rutil, Quarz, Talk, Silikate, Tonerden, Wollastonit, Zirkon, Aluminiumnitrid, Aluminiumoxid, Bornitrid, Zinkoxid, Siliciumnitrid und Siliciumcarbid sowie Mischungen solcher Füllstoffe. In einer bevorzugten Ausführungsform ist der Füllstoff Aluminiumnitrid.

Die Herstellung der gefüllten Klebstoffe kann nach in der Technik bekannten Mischverfahren und die Herstellung der erfindungsgemässen Laminate nach bekannten Beschichtungsmethoden (Streichen, Rakeln, Vorhanggiessen, Schleudergiessen oder Pressverfahren) erfolgen.

Die erfindungsgemässen Laminate können eben oder bevorzugt in ihrer Form so gestaltet sein, dass sie erhabenen oder vertieften Bereichen eines Bauelements (zum Beispiel einem Montagestreifen) angepasst sind, mit dem sie verbunden werden.

Die erfindungsgemässen Laminate eignen sich hervorragend zur Bildung einer Wärmebrücke, indem man die elektrischen Leiterbahnen eines Montagestreifens mit dessen elektrisch isolierten Bereichen verklebt. Man erzielt hierbei in elektrischen und elektronischen eingekapselten Bauteilen eine überraschend hohe Wärmeabfuhr. Der thermische Widerstand $\Theta_{JA}$ kann bis zu dreimal kleiner sein als bei konventionellen Bauteilen ohne oder mit Luftkühlung. Für eine wirksame Wärmeableitung genügt sogar die Verklebung mit den Endbereichen der elektrischen Leiterbahnen. Mit der Anpassung der Form des Laminats und der Wahl der Materialen können unter Berücksichtigung der thermischen Ausdehnungskoeffizienten der verwendeten Führungsrahmen so weitgehend thermomechanisch bedingte Spannungen verhindert und eine lange Lebensdauer von eingekapselten elektronischen Bauteilen, zum Beispiel DIP-Gehäusen, gewährleistet werden.

In einer besonders vorteilhaften Ausgestaltungsform können für die Bildung einer Wärmebrücke dielektrische und selbsttragende Klebfilme verwendet werden, die einen wärmeleitenden Füllstoff enthalten. Für die Klebfilme und die Füllstoffe gelten die gleichen Ausgestaltungen und Bevorzugungen wie für die Klebschichten der erfindungsgemässen Laminate.

Auch die Klebfilme können eben oder bevorzugt in ihrer Form so gestaltet sein, dass sie erhabenen und-/oder vertieften Bereichen eines Bauelements, zum Beispiel eines Montagestreifens, angepasst sind. Die Wärmeableitung der Klebfilme liegt überraschend im Bereich der Werte, die für die erfindungsgemässen Laminate gefunden werden. Ein besonderer Vorteil besteht gegenüber dem erfindungsgemässen Laminat darin, dass durch das Weglassen des metallischen Trägermaterials zum einen thermomechanische Spannungen weiter verringert werden können und zum anderen eine sehr gute Haftung zwischen den Verbundmaterialien erzielt werden kann, besonders wenn die Klebharze und anderen Kunststoffe, zum Beispiel Umhüllungsharze für einen Montagestreifen, aus dem gleichen Basismaterial wie zum Beispiel Epoxidharzen bestehen. Ferner ist die Herstellung von Montagestreifen und DIP-Gehäusen vereinfacht und wirtschaftlicher.

Die Klebfilme weisen eine Wärmeleitfähigkeit von mindestens 1 W/mK und bevorzugt eine Dicke von 5 bis 500 μm auf.

Ein weiterer Gegenstand der Erfindung ist ein Montagestreifen mit elektrischen Leiterbahnen und elektrisch isolierten Auflageflächen für elektrische und elektronische Bauelemente, bei dem die Leiterbahnen und die Rückseiten der Auflageflächen mit einem erfindungsgemässen Laminat oder einem dielektrischen und selbsttragenden Klebfilm, der einen wärmeleitenden Füllstoff enthält und eine Wärmeleitfähigkeit von mindestens 1 W/mK aufweist, verklebt sind.

Der Montagestreifen kann auf einer Seite gesamthaft mit dem Laminat oder dem Klebfilm verklebt sein. Die aus Metallen oder Metallegierungen, zum Beispiel Kupfer, Aluminium oder Kupfer/Nickel-Legierungen, gebildeten Leiterbahnen sind gute Wärmeleiter, so dass eine teilweise Verklebung genügt. In einer bevorzugten Ausführungsform sind nur die Endbereiche der Leiterbahnen mit dem Laminat oder dem Klebfilm verklebt, die an die Auflagefläche angrenzen.

Die Herstellung der erfindungsgemässen Montagestreifen kann nach bekannten Verfahren durch Verkleben mit dem Laminat oder dem Klebfilm, gegebenenfalls unter Erwärmung und/oder Druck erfolgen.

Ein anderer Gegenstand der Erfindung ist die Verwendung des mit dem Laminat oder dem Klebfilm verklebten Montagestreifens zur Herstellung von elektrischen und elektronischen Bauteilen, insbesondere von DIP-Gehäusen. Die Herstellung solcher Bauteile ist bekannt. Zum Beispiel kann man so vorgehen, dass man ein elektrisches oder elektronisches Bauteil, zum Beispiel einen Halbleiter, gegebenenfalls mit einem Klebmittel auf der Auflagefläche fixiert, dieses mit den elektrischen Leiterbahnen kontaktiert und danach mit einer Kunststoffformmasse einkapselt. Kunststoffe zur Umhüllung von elektrischen und elektronischen Bauteilen sind allgemein bekannt. Häufig werden hierfür Epoxidharze verwendet.

Ein weiterer Gegenstand der Erfindung ist ein Verfahren zur Ableitung von Wärme aus dem Bereich der elektrisch isolierten Auflageflächen für elektrische und elektronische Bauelemente von Montagestreifen, die mit einem Kunststoff eingekapselt sind, insbesondere in DIP-Gehäusen, das dadurch gekennzeichnet ist, dass man die Rückseiten der Auflageflächen und die elektrischen Leiterbahnen des Montagestreifens mit einem erfindungsgemässen Laminat oder einem dielektrischen und freitragenden Klebfilm, der einen wärmeleitenden Füllstoff enthält und der eine Wärmeleitfähigkeit von mindestens 1 W/mK aufweist, als Wärme ableitende Schicht verklebt.

Der erfindungsgemässe Montagestreifen eignet sich ganz besonders zur Herstellung von DIP-Gehäusen, bei denen eine wirksame Wärmeabfuhr während des Betriebs erwünscht ist. Ein weiterer Gegenstand der Erfindung sind DIP-Gehäuse, die einen Montagestreifen enthalten, bei dem die Rückseiten elektrisch isolierter Auflageflächen für Halbleiterbauteile und elektrische Leiterbahnen mit einem erfindungsgemässen Laminat oder einem dielektrischen und selbsttragenden Klebfilm, der einen wärmeleitenden Füllstoff enthält und der eine Wärmeleitfähigkeit von mindestens 1 W/mK aufweist, verklebt sind. Vorzugsweise sind nur die Endbereiche der Leiterbahnen mit dem Laminat oder dem Klebfilm verklebt. In einer bevorzugten Ausführungsform ist die Form des Laminats oder des Klebfilms so gestaltet, dass sie an erhabene und vertiefte Bereiche des Montagestreifens angepasst sind. Durch diese Gestaltung kann eine durch thermomechanische Zugbeanspruchungen bedingte Rissbildung praktisch ausgeschlossen werden.

Die für das Laminat angegebenen Bevorzugungen gelten auch für die anderen Gegenstände der Erfindung.

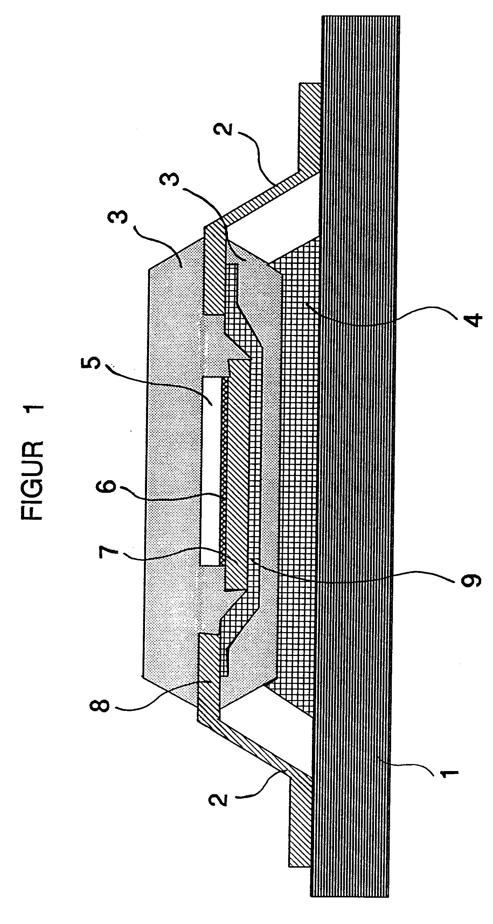

In Figur 1 ist der Querschnitt eines erfindungsgemässen DIP-Gehäuses mit einem eingekapselten Chip dargestellt. Auf einem Substrat (1) ist ein Montagestreifen (2) aufgebracht, der aus den metallischen Leiterbahnen (8) und der Auflagefläche (7) besteht. Das Umhüllungsharz (3) ist über eine thermisch leitende Paste (4) mit dem Substrat (1) verbunden. Der Chip (5) ist mit der Klebschicht (6) auf der Auflagefläche (7) des Montagestreifens (2) fixiert. Die Auflagefläche (7) ist mit den metallischen Leiterbahnen (8) des Montagestreifens (2) durch das erfindungsgemässe Laminat (9) oder einen dielektrischen und selbsttragenden Klebfilm (9), der einen wärmeleitenden Füllstoff enthält, verbunden.

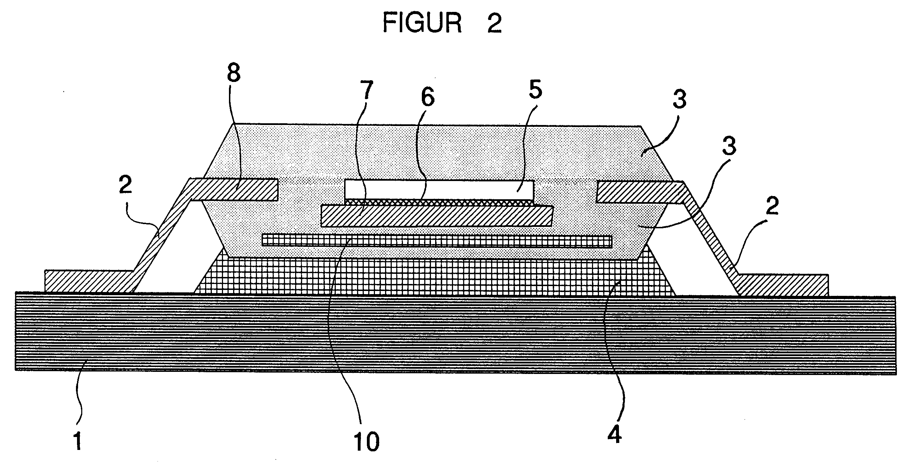

In Figur 2 ist der Querschnitt eines entsprechenden DIP-Gehäuses dargestellt, bei dem anstelle des erfindungsgemässen Laminats (9) eine Metallplatte (10) unter der Auflagefläche (7) im Umhüllungsharz (3) eingebettet ist.

Die nachfolgenden Beispiele erläutern die Erfindung näher.

Beispiel 1: Herstellung eines Laminats.

67,2 Gew.-% Aluminiumnitrid mit einem mittleren Teilchendurchmesser von 30 µm und einem maximalen Durchmesser von 100 µm werden in eine Formulierung aus 14,92 Gew.-% eines vorverlängerten Epoxidharzes [Voraddukt aus 66,4 Gew.-% Bisphenol-A-Diglycidylether, 30,5 Gew.-% Bisphenol-A und 3,1 Gew.-% Paratertiärbutylphenol (Araldit® 7097), wovon 73,73 Gew.-% mit 19,82 Gew.-% carboxylterminierten Polybutadien-Acrylnitril-Copolymer (Hycar® CTBN 1300X13) und 6,45 Gew.-% Bisphenol-A umgesetzt werden], 4,4 Gew.-% Bisphenol-A-Diglycidylether, 0,28 Gew.-% Polyether-Polyamid-Blockcopolymer (Pebax® 2533, Atochem), 9,33 Gew.-% Elastomer modifiziertes Epoxidharz [Umsetzungsprodukt aus 34,89 Gew.-% Araldit® 7097, 16,79 Gew.-% Hycar® CTBN 1300X13, 34,76 Gew.-% festes Bisphenol-A-Epoxidharz, (Araldit® B) und 0,56 Gew.-% Bisphenol-A, Epoxidäquivalentgewicht 1,1 Aequivalente/kg], 0,47 Gew.-% Araldit® 7097, 1 Gew.-% Cashew Nut Shell Oel (CNSL Oel), 0,28 Gew.-% Aerosil®, 0,46 Gew.-% Trimethoxy-(glycidyloxypropyl)silan (Haftvermittler), 0,46 Gew.-% Glycidylester der tertiären Carbonsäure Versatic® 10 (Cardura® E 10), 0,92 Gew.-% Dicyandiamid, 0,06 Gew.-% Chlortoluron und 0,22 Gew.-% Mannichbase aus Poly-p-vinylphenol, Dimethylamin und Formaldehyd (EP 797, Shell) eingearbeitet. Aus der erhaltenen klebrig-weichen Masse wird durch Rakeln ein Schmelzklebefilm hergestellt, der unter Druck auf eine Kupferfolie mit einer Dicke von 35 µm laminiert wird. Die Wärmeleitfähigkeit der Klebschicht dieses flexiblen Laminats beträgt 1,5 W/mK und deren Dicke 240 µm.

Beispiel 2: Herstellung eines Montagestreifens mit dem Laminat gemäss Beispiel 1.

Das Laminat gemäss Beispiel 1 wird so auf der Rückseite einer elektrisch isolierten Auflagefläche eines 16-Pin Montagestreifens aus Kupfer fixiert, dass die Enden der elektrischen Leiterbahnen bedeckt sind. Die Verklebung wird durch Härtung bei 180 °C während einer halben Stunde vorgenommen. Danach ist das Laminat fest mit dem Montagestreifen verbunden.

Beispiel 3: Herstellung eines DIP-Gehäuses.

Auf der Vorderseite der Auflagefläche des Montagestreifens gemäss Beispiel 2 wird ein Heizelement und ein Thermoelement aufgeklebt. Anschliessend wird der Montagestreifen in einer Form mit einem Epoxidharz eingekapselt, das eine Wärmeleitfähigkeit von 0,2 W/mK aufweist. Als Epoxidharz werden 185 g Bisphenol-A-Diglycidylether (Araldit® GY 260) und als Härter 29,5 g Trimethylhexamethylendiamin verwendet. Hierbei wird das Harz in die Form gegossen und bei einer Temperatur von 180 °C ausgehärtet, so dass der Montagestreifen mit einer 0,2 cm dicken Harzschicht vollständig eingekapselt ist. Der thermische Widerstand $\Theta_{JA}$ wird zu 21 W/mK ermittelt.

Beispiel 4: Herstellung von Laminaten und eines selbsttragenden Klebfilms.

Gemäss Beispiel 1 werden die folgenden Bestandteile vermischt: 43,7 Gew.-% Bisphenol-A-Diglycidylether, 9,7 Gew.-% Epoxy-Phenol-Novolak, 26,1 Gew.-% Epoxy-Kresol-Novolak, 12,3 Gew.-% Härter aus je 50 Gew.-Teilen Bisphenol-A-Diglycidylether und Dicyandiamid, 5,2 Gew.-% Beschleuniger aus 73 Gew.-Teilen Bisphenol-A-Diglycidylether und 27 Gew.-Teilen einer Mischung aus 52,3 Gew.-Teilen 2,4,6-Tris-(dimethylaminomethyl)-phenol und 47,7 Gew.-Teilen Poly-4-vinylphenol, und 3 Gew.-% Phenoxyharz (Poly-Bisphenol-A-digycidylether).
Ein Teil der Mischung wird mit AlN ( 74 Gew.-% mit Teilchendurchmesser 40 µm und 26 Gew.-% mit Teilchendurchmesser 1 µm) vermischt (Gesamtzusammensetzung 75,4 Gew.-% AlN und 24,6 Gew.-% Harz).
Ein weiterer Teil wird mit Quarzpulver (Teilchendurchmesser 30 µm) vermischt (Gesamtzusammensetzung 70 Gew.-% Füllstoff und 30 Gew.-% Harz).
Gemäss Beispiel 1 werden aus diesen Mischungen selbstragende Klebfilme hergestellt, die eine Dicke von 200 µm aufweisen. Die Klebfilme werden teilweise direkt weiterverarbeitet und teilweise gemäss Beispiel 1 auf eine Kupferfolie (35 µm Dicke) und eine Aluminiumfolie (10 µm Dicke) laminiert. Man erhält damit folgende Klebfilme und Laminate:
Klebfilm A (Füllstoff AlN).
Klebfilm B (Füllstoff Quarzpulver).
Laminat C (Kupferfolie mit Klebfilm A).
Laminat D (Kupferfolie mit Klebfilm B).
Laminat E (Aluminiumfolie mit Klebfilm A).
Die Klebfilme und Laminate werden gemäss Beispiel 2 mit Montagestreifen verklebt und aus diesen Montagestreifen gemäss Beispiel 3 DIP-Gehäuse hergestellt. Es werden folgende thermischen Widerstände $\Theta_{JA}$ ermittelt:

Klebfilm A: 25 K/W
Klebfilm B: 37 K/W
Laminat C: 20 K/W
Laminat D: 22 K/W
Laminat E: 25 K/W

**Patentansprüche**

1. Laminat aus (a) einem Trägermaterial mit einer Wärmeleitfähigkeit von mindestens 10 W/mK und einer Dicke von 10 bis 100 µm, bei dem (b) auf mindestens einer Oberfläche eine dielektrische Klebschicht aufgebracht ist, die einen wärmeleitenden Füllstoff enthält, und die eine Dicke von 5 bis 500 µm und eine Wärmeleitfähigkeit von mindestens 1 W/mK aufweist.

2. Laminat gemäss Anspruch 1, dadurch gekennzeichnet, dass das Trägermaterial aus Filmen, Folien oder Geweben von Metallen, Metallegierungen, oder aus Kunststoffen mit hoher Wärmeleitfähigkeit und Schmelzpunkten von mehr als etwa 150 °C, oder aus Geweben von Kohlenstoff- oder Keramikfasern besteht.

3. Laminat gemäss Anspruch 1, dadurch gekennzeichnet, dass das Trägermaterial aus Metallen oder Metallegierungen besteht.

4. Laminat gemäss Anspruch 3, dadurch gekennzeichnet, dass das Trägermaterial aus Kupfer, Nickel, Zink, Aluminium oder Legierungen aus Kupfer und Nickel besteht.

5. Laminat gemäss Anspruch 1, dadurch gekennzeichnet, dass das Trägermaterial eine Wärmeleitfähigkeit von mindestens 20 W/mK aufweist.

6. Laminat gemäss Anspruch 1, dadurch gekennzeichnet, dass das Trägermaterial eine Dicke von 10 bis 70 µm aufweist.

7. Laminat gemäss Anspruch 1, dadurch gekennzeichnet, dass die Klebschicht aus einem pastösen, zähflüssigen oder festen Klebstoff gebildet ist.

8. Laminat gemäss Anspruch 1, dadurch gekennzeichnet, dass die Klebschicht aus einem Klebfilm oder einem Schmelzkleber gebildet ist.

9. Laminat gemäss Anspruch 1, dadurch gekennzeichnet, dass die Klebschicht ein Epoxidharz als Klebstoff enthält.

10. Laminat gemäss Anspruch 1, dadurch gekennzeichnet, dass die Dicke der Klebschicht 20 bis 300 µm beträgt.

11. Laminat gemäss Anspruch 1, dadurch gekennzeichnet, dass die Klebschicht eine Wärmeleitfähigkeit von mindestens 1,5 W/mK aufweist.

12. Laminat gemäss Anspruch 1, dadurch gekennzeichnet, dass die Klebschicht einen wärmeleitenden Füllstoff enthält, der feinteilig ist und eine Partikelgrösse aufweist, die nicht grösser und bevorzugt kleiner als die Dicke der Klebschicht ist.

13. Laminat gemäss Anspruch 12, dadurch gekennzeichnet, dass es sich bei dem wärmeleitenden Füllstoff um ein natürliches oder synthetisches Mineral oder einen keramischen Werkstoff handelt.

14. Laminat gemäss Anspruch 12, dadurch gekennzeichnet, dass es sich bei dem wärmeleitenden Füllstoff um Aluminiumnitrid handelt.

15. Laminat gemäss Anspruch 1, dadurch gekennzeichnet, dass es in seiner Form so gestaltet ist, dass es sich erhabenen oder vertieften Bereichen eines Bauelements anpasst, mit dem es verbunden wird.

16. Montagestreifen mit elektrischen Leiterbahnen und elektrisch isolierten Auflageflächen für elektrische und elektronische Bauelemente, bei dem die Leiterbahnen und die Rückseiten der Auflageflächen mit einem Laminat gemäss Anspruch 1 oder einem dielektrischen und selbsttragenden Klebfilm, der einen wärmeleitenden Füllstoff enthält und eine Wärmeleitfähigkeit von mindestens 1 W/mK aufweist, verklebt sind.

17. Montagestreifen gemäss Anspruch 16, dadurch gekennzeichnet, dass nur die Endbereiche der Leiterbahnen mit dem Laminat oder dem Klebfilm verklebt sind, die an die Auflagefläche angrenzen.

18. Verwendung des Montagestreifens gemäss Anspruch 16 zur Herstellung von elektrischen und elektronischen Bauteilen.

19. Verwendung gemäss Anspruch 18 zur Herstellung von DIP-Gehäusen.

20. Verfahren zur Ableitung von Wärme aus dem Bereich der elektrisch isolierten Auflageflächen für elektrische und elektronische Bauelemente von Montagestreifen, die mit einem Kunststoff umhüllt sind, dadurch gekennzeichnet, dass man die Rückseiten der Auflageflächen und die elektrischen Leiterbahnen des Montagestreifens mit einem Laminat gemäss Anspruch 1 oder einem dielektrischen und selbsttragenden Klebfilm, der einen wärmeleitenden Füllstoff enthält und eine Wärmeleitfähigkeit von mindestens 1 W/mK aufweist, als Wärme ableitende Schicht verklebt.

21. DIP-Gehäuse, die einen Montagestreifen enthalten, bei dem die Rückseiten elektrisch isolierter Auflageflächen für Halbleiterbauteile und elektrische Leiterbahnen mit einem Laminat gemäss Anspruch 1 oder einem dielektrischen und selbsttragenden Klebfilm, der einen wärmeleitenden Füllstoff enthält und eine Wärmeleitfähigkeit von mindestens 1 W/mK aufweist, verklebt sind.

FIGUR 1

FIGUR 2

EP 0 511 162 A1

**Europäisches Patentamt**

# EUROPÄISCHER RECHERCHENBERICHT

Nummer der Anmeldung

EP 92 81 0279

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | GB-A-2 060 435 (SHOWA DENKO)<br><br>* Seite 2, Zeile 10 - Zeile 46 *<br>--- | 1-5,7, 9-15 | H01L23/373<br>H01L23/495 |
| Y | EP-A-0 309 982 (E.I. DU PONT DE NEMOURS)<br><br>* Seite 3, Zeile 43 - Seite 4, Zeile 8; Ansprüche 38,40 *<br>--- | 1-5,7, 9-15 | |
| A | FR-A-2 597 261 (SOCIETE DE COMPOSANTS D'AIX-LES-BAINS)<br>* Seite 8, Zeile 10 - Seite 9, Zeile 12; Abbildungen 4,5 *<br>--- | 1,2, 15-21 | |
| A | EP-A-0 257 466 (GENERAL ELECTRIC COMPANY)<br>* Zusammenfassung *<br>* Spalte 8, Zeile 34 - Zeile 40 *<br>* Spalte 10, Zeile 5 - Zeile 12 *<br>* Spalte 27, Zeile 7 - Zeile 28 *<br>--- | 1-4,9 | |
| A | PATENT ABSTRACTS OF JAPAN<br>vol. 9, no. 31 (E-295)9. Februar 1985<br>& JP-A-59 175 753 ( TOSHIBA ) 4. Oktober 1984<br>* Zusammenfassung *<br>--- | 1,2,9, 15-21 | **RECHERCHIERTE SACHGEBIETE (Int. Cl.5 )**<br><br>H01L |
| A | PATENT ABSTRACTS OF JAPAN<br>vol. 14, no. 263 (E-938)7. Juni 1990<br>& JP-A-2 082 559 ( DENKI KAGAKU KOGYO ) 23. März 1990<br>* Zusammenfassung *<br><br>----- | 1-4 | |

Der vorliegende Recherchenbericht wurde für alle Patentansprüche erstellt

| Recherchenort | Abschlußdatum der Recherche | Prüfer |
|---|---|---|
| BERLIN | 22 JUNI 1992 | LE MINH I. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................
& : Mitglied der gleichen Patentfamilie, übereinstimmendes Dokument

EPO FORM 1503 03.82 (P0403)